# EUROPEAN PATENT SPECIFICATION

(11) **EP 3 605 583 B1**
(45) Date of publication and mention of the grant of the patent: **12.05.2021**
(21) Application number: 18382577.7
(22) Date of filing: 31.07.2018
(51) Int. Cl.: H01J 37/34, C23C 14/35

(54) **DEVICE FOR THE STABLE MANUFACTURE OF NANOCLUSTERS**
VORRICHTUNG ZUR STABILEN HERSTELLUNG VON NANOCLUSTERN
DISPOSITIF DE FABRICATION STABLE DE NANOCLUSTERS

(43) Date of publication of application: 05.02.2020
(73) Proprietor: Consejo Superior de Investigaciones Científicas (CSIC), 28006 Madrid (ES); Nano4energy SLNE, 28014 Madrid (ES)
(72) Inventor: HUTTEL, Yves, 28049 MADRID (ES); MARTÍNEZ ORELLANA, Lidia, 28049 MADRID (ES); FERNÁNDEZ MARTÍNEZ, Iván, 28014 MADRID (ES)
(74) Representative: Pons Ariño, Angel

(56) References cited:
- EP-A1- 0 525 295
- EP-A1- 3 006 594
- ES-A1- 2 364 773
- US-A1- 2004 259 362

## Description

The invention relates to a magnetron sputtering device for the generation and deposition of nanoclusters and nanoparticles, and more particularly, to a magnetron sputtering device wherein the magnetron is a full face erosion magnetron. The combination of full face erosion magnetron with a gas aggregation source allows the generation of a stable nanoclusters or nanoparticles beam overtime and produces an improvement of the use of the target surface in more than 100%. In addition, the injection of gases, apart from the sputtering gas, increases both, the stability and the production rate of the nanoparticle flux. The invention can be included in the field of the nanotechnology and the chemical nano-synthesis.

### BACKGROUND ART

There is an increasing interest in the generation of nanoparticles (NPs) or nanoclusters not only because of their size-related specific properties, but also because they are promising building blocks for more complex materials in nanotechnology.

The production of nanoclusters by gas phase synthesis has been developed and widely used in the 80's and 90's by groups interested in studying their properties and their interaction with surfaces. With the advent of the nanotechnology the gas phase synthesis technology has evolved to the fabrication of well-controlled nanoclusters. All variants of the technology are based on the atomization of a material, followed by the controlled coalescence of the atoms into nanoclusters that are collected.

Sputtering technology, especially planar magnetron sputtering, is widely used in the generation of nanoclusters and deposition process of said nanoclusters, because of the high rate and wide area of deposition. However, the magnetron discharge plasma is not uniform, so the total target utilization is only about 10% (in order to reach 10%, both sides of the target are used as each side allows the use of only 5%. This means that the system that is vacuum or ultra-high vacuum vessel needs to be exposed to air for the flipping of the target) for conventional planar magnetron sputtering in general due to the narrow and deep groove erosion on the target, which it is known as "racetrack" which is produced on the target as a result of localized magnetic field and then plasma distribution on the target surface. This erosion is regarded as a serious disadvantage of the magnetron sputtering because it degrades the lifetime usage of the target for the generation of the NPs in gas phase.

In a previous European patent application [EP3006594 A1 (Japan Science & Tech agency; Ayabo Corp)] it is disclosed a nanocluster apparatus that comprises in a vacuum chamber a sputtering source (magnetron), a first inert gas supply device, a second inert gas device, a target, an arrangement of magnets and a grown chamber space length greater than the cell inner diameter. It is a common magnetron device wherein the "racetrack" is produced.

In other previous European patent application [EP0525295 A1 (LEYBOLD AG)] it is disclosed a magnetic arrangement for a magnetron device that comprises a stationary outer ring magnet and magnets with opposing polarity on a rotating disc in order to achieve full face target erosion for improving the layer thickness distribution on the substrates to be coated to the conventional cathodes in a magnetron sputtering cathode, so the aim of this patent is to have a standard size FFE type magnetron, which avoids for example having more than one FFE magnetron in the same vacuum chamber and for the use of standard size targets.

In addition, a previous Spanish patent application [ES2364773 A1 (CSIC)] discloses a moving magnetron, a second chamber and deposition mean in order to improve the nanoparticles obtained by this magnetron.

The change in the target erosion profile is the most commonly source of instability and it is important to address this issue to access prolonged operation and reliable production of nanoclusters.

For this reason, the problem of said sputtering devices are the instabilities for long production times that must be addressed for the further scaling-up and mass production of nanoclusters and NPs with this technology. In this sense, the injection of gases, apart from the sputtering gas, increases both, the stability and the production rate of the nanoparticle flux for long periods of time.

### SUMMARY OF THE INVENTION

The present invention discloses a novel device for the production of nanoclusters based on magnetron sputtering wherein said device comprises at least one full face erosion magnetron (FFE). Said FFE magnetron is arranged for avoiding the appearance of the localized erosion profile or 'racetrack' in the target. The FFE is inserted in an aggregation zone, typical from gas aggregation sources. In addition, the possibility to insert one or more than one FFE in an aggregation zone is due to the miniaturization achieved in the present invention of the FFE.

The new features of the present invention are based in the replacement of standard 1" (2.54 cm) to 12" (30.48 cm) diameter magnetron by a 1" (2.54 cm) to 12" (30.48 cm) diameter FFE magnetron mounted in an aggregation zone. The magnetron can be placed at different positions in the aggregation zone in an independent manner. The magnetron can hold a sputtering target from any conductor, semiconductor or isolating material that is vacuum or ultra-high vacuum compatible. The following examples of these materials illustrate the invention without restricting the scope thereto: Au, Ag, Pt, Fe, Co, Cu, C or their alloys as conductive materials; Si as semiconductor or SiC as isolating material.

The injection of additional gases, apart from the sputtering gas, increases the stability and the production rate of the nanoparticle flux for the long periods of time that allows the use of FFE.

The advantages of the device of the present invention are:
- the weight consumption of the target using a FFE as magnetron is higher with respect to that of the standard magnetron sputtering where the used target volume is no more than 5% (10% if the target is used on both sides)
- the target used in the FFE magnetron has been operated during more than 12 hours at an average power of 90 W without the need to be exchanged.
- the stability of the nanoparticle flux over long periods of working time due to the injection of secondary gases through the cooling and seeding effects.

A first aspect of the present invention relates to a magnetron sputtering device for the generation of nanoclusters according to claim 1.

The term "nanocluster" refers herein to any cluster of nanoparticles and/or to any nanoparticle with an average size of between 0.5 nm and 1 µm.

The term "target" refers to any conductor, semiconductor or isolating material that is ultra-high or high vacuum compatible and said materials can be held in magnetron. The following examples of these materials illustrate the invention without restricting the scope thereto: Au, Ag, Pt, Fe, Co, Cu, C or their alloys as conductive materials; Si as semiconductor or SiC as isolating material. The term "high vacuum or HV" refers but not limited herein to any pressures characterized by pressures between 10⁻⁷ Pa and 10⁻⁴ Pa.

The term "ultra-high vacuum or UHV" refers but not limited herein to any pressures characterized by pressures lower than about 10⁻⁷ Pa.

The term "cooling gas or gas that produces a cooling effect" refers to any gas that can absorb an excess of energy or heat. In the present invention one of the following gases is provided: O₂, N₂, H₂O, methanol, air and any combination thereof.

The term "seeding gas or gas that produces a seeding effect" refers to any gas that can act as nucleation point for the coalescence of atoms or ions. In the present invention one of the following gases is provided: O₂, N₂, H₂O, methanol, air and any combination thereof.

The term "full face erosion magnetron or FFE magnetron" refers herein to any magnetron arranged to the moving of the magnets to sweep the plasma over the whole surface of the target that gives rise to a homogeneous erosion of the target. This is achieved by the combination of a stationary magnetic ring with a rotational magnetic disc.

The modification of the dimensions of the full face erosion magnetron allows its insertion in vacuum or ultra-high vacuum vessels with different apertures and sizes. In the case of the reduction of the size of the full face erosion magnetron, all parts (magnets, ceramics, water tubes, electrical connections) are reduced. These reductions in size of the parts are performed by a careful design of the parts in such a way that their functionalities (magnetic strength, cooling, insulating and conducting capacities) are adapted. In particular a magnetic modelling is required to achieve the optimum magnetic field at the surface of the target in order to generate the required plasma for the generation of the nanoclusters.

Thus in a preferred embodiment of the magnetron sputtering device, the stationary magnetic ring has a diameter of between 2" (5.08 cm) and 10" (25.4 cm), and the rotational magnetic disc having the inverse polarity of the stationary magnetic ring has a diameter of between 1" (2.54 cm) and 9" (22.86 cm), and wherein the target has a diameter of between 2" (5.08 cm) and 10" (25.4 cm).

In other embodiment of the magnetron sputtering device, the first chamber comprises one or more than one magnetron.

In other embodiment of the magnetron sputtering device of the present invention the magnetron is arranged for moving towards the "a" axis in the first chamber.

In other embodiment of the magnetron sputtering device of the present invention further comprises at least a second chamber

In a preferred embodiment of the magnetron sputtering device said magnetron sputtering device the second chamber comprises a deposition or analysis or manipulation means of nanoclusters working under high or ultra-high vacuum. In a more preferred embodiment, the substrate onto which the nanoclusters are deposited is selected from Si wafer, transmission electron microscopy grids, grafite, polymer, metallic and semiconductor substrates and any combination thereof, and the second chamber is arranged for the substitution of the substrate.

In other embodiment of the magnetron sputtering device, the second chamber comprises an analysis means of nanoclusters working under high or ultra-high vacuum. In a preferred embodiment the analysis means are selected from a, mass spectrometer, infrared bath, X-Ray photoelectron spectroscopy (XPS), ultraviolet photoelectron spectroscopy (UPS), Auger electron spectroscopy (AES) low-energy ion spectroscopy (LEIS) thermal desorption spectroscopy and any combination thereof.

In other embodiment of the magnetron sputtering device, the second chamber comprises the deposition means and the analysis means described herein.

In another embodiment of the magnetron sputtering device of the present invention further comprises a separation means between the first and second chamber, and filtering means of the nanocluster.

In a more preferred embodiment of the magnetron sputtering device the separation and filtering means are selected from electromagnetic particle filter, oven, deflecting coils, beam focusing lens, ion traps, and any combination thereof.

Unless otherwise defined, all technical and scientific terms used herein have the same meaning as commonly understood by one of ordinary skilled in the art to which this invention belongs. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples and drawings are provided by way of illustration and are not intended to be limiting of the present invention, which is defined by the claims.

### BRIEF DESCRIPTION OF THE DRAWINGS

**Fig. 1****.** Comparison of ion current, as a function of nanoparticles diameter, generated in a gas phase source with a flat target and a used target with a racetrack formed.
**Fig. 2****.** Surface images of targets after a) 5% use in standard magnetron and b) more than 20% use in a Full Face Erosion magnetron; profilometry of the targets used in c) standard magnetron and d) FFE magnetron.
**Fig.3****.** Comparison of the depth profiles depicted in Fig.2c) and Fig.2d).
**Fig. 4****.** Schematic view of both the stationary magnetic ring and second rotational magnetic disc.
**Fig. 5****.** Scheme of magnetron sputtering device, which comprise a FFE as a magnetron is shown. (1) First chamber, named aggregation zone; (2) target; (3) FFE magnetron; (4) gas inlet; (5) second chamber; (6) substrate; (7) gas inlet; (8) connection between first and second chamber.
**Fig. 6****.** Atomic Force Microscopy (AFM) images of deposit of Au nanoparticles on Si wafer in a) absence and b) presence of air. c) and d) Profiles of the AFM images above.
**Fig. 7****.** The effects of the addition of water vapor and methanol that had use the combination of FFE with the aggregation source for the manufacture of gold nanoparticles.
**Fig. 8****.** Comparison in the nanoparticles deposited in conditions of absence and presence of methanol for short and long operation times.
**Fig. 9****.** Scanning Electron Microscopy (SEM) image of Au nanoparticles generated with a FFE as a magnetron and a methanol addition.

### EXAMPLES

### Example 1 Evidences of detrimental effect of racetrack formation and how to avoid it with FFE

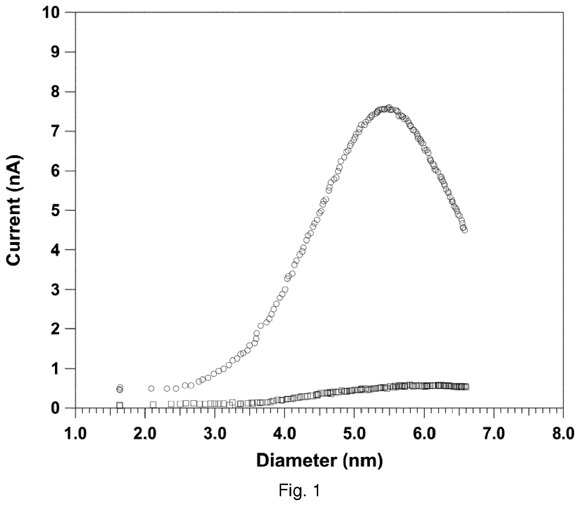

The effect of the racetrack formation on the synthesis rate of gold nanoparticles can be seen in figure 1. Both curves represent the evolution of the ion current (that is proportional to the number of fabricated nanoparticles) measured with a quadrupole mass filter in the case of a new and flat gold target (upper curve) and for a used target were the racetrack is well formed (bottom curve). In both cases, all operation parameters were kept identical. As can be clearly observed, the flat target allows the production of a more intense NPs beam that is nearly one order of magnitude more intense than for the used target.

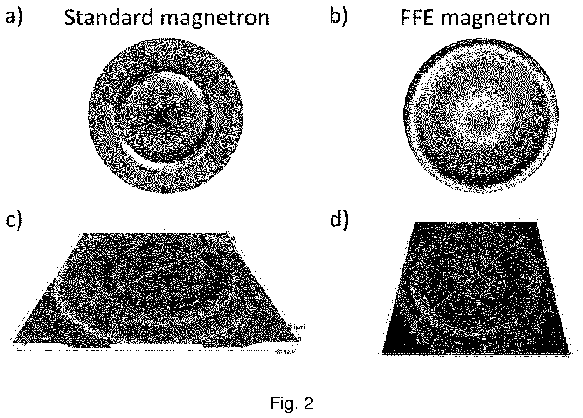

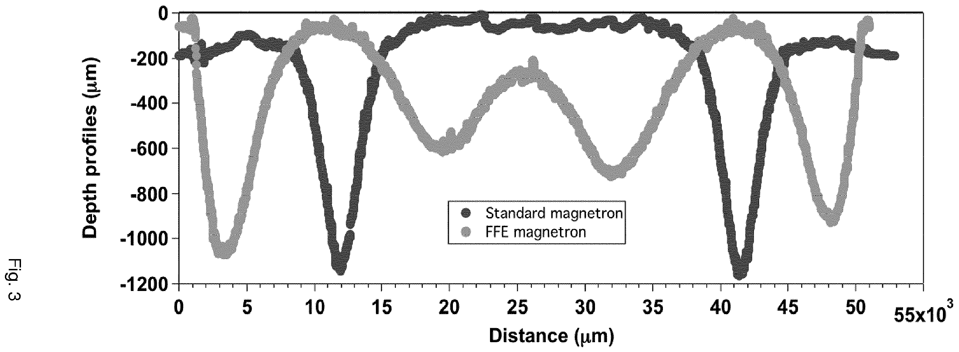

However, due to the usage of an FFE magnetron, the target wear is much more uniform (Figure 2), avoiding the formation of a narrow racetrack (Figure 3). In this way, the decrease on the NP beam described in figure 1 with the formation of the racetrack is avoided, and a longer use of the target is achieved.

### Example 2 Effect of the inclusion of additional gases

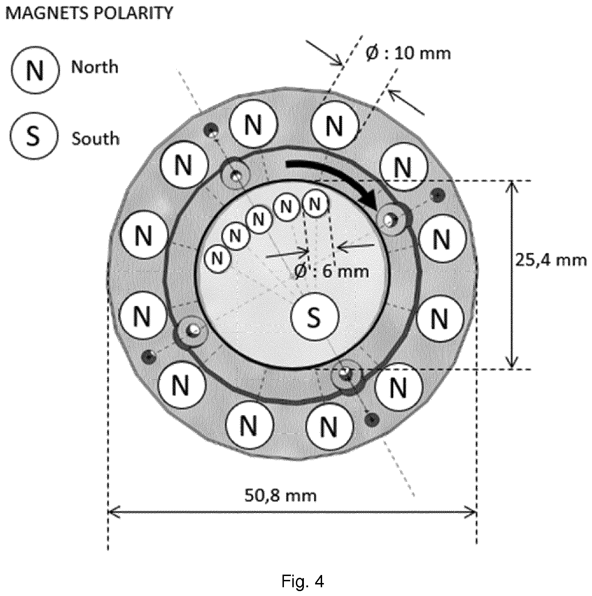

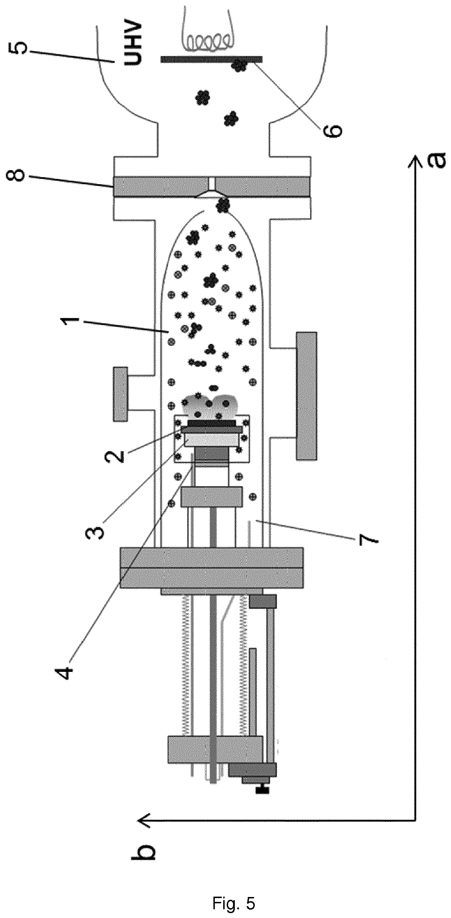

Gold nanoparticles were fabricated using a 2" (5.08 cm) FFE magnetron (3) with an arrangement of magnets depicted in figure 4. The FFE magnetron is placed into the gas aggregation source (Figure 5), i.e. avoiding therefore the strong influence of the racetrack formation and evolution upon time. The target is a 5.08 cm gold target (2) that is fixed in the magnetron head. The applied power was 90 W, the argon flux was 80 standard cubic centimeters per minute (sccm) and no helium was added by the first gas source (4) in the aggregation zone (1).

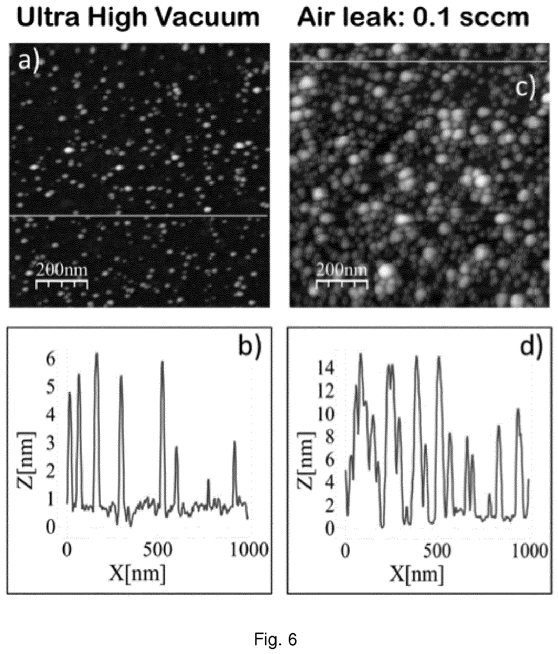

At the initial stages a second gas is injected by the secondary gas source (7). This second gas can be any gas that could help in the fabrication process in terms of stability and production rate. As an example, figure 6 presents a comparison of an Au NP deposit fabricated using the same working parameters, but one in absence and another in presence of an air leak (0.1 sccm). It is evident that the presence of air induces a significant increase of both, the NP size and the number of NPs deposited in the same deposition time.

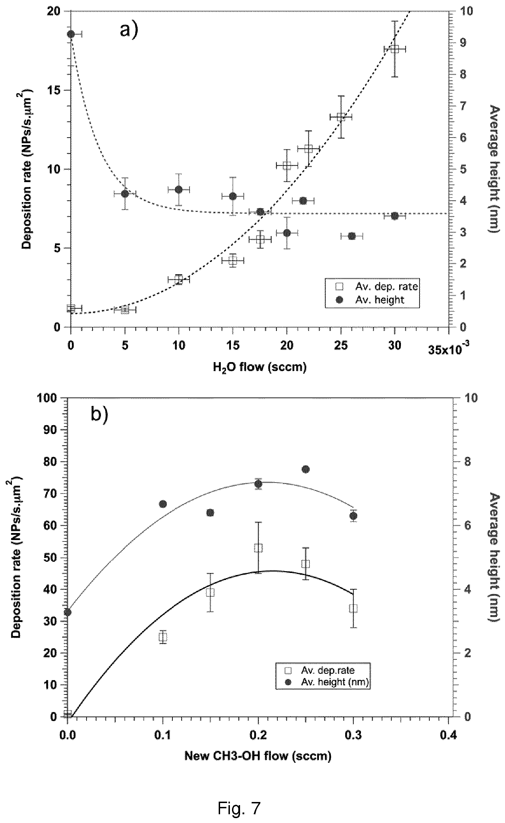

Other examples are presented in figure 7, where different doses of water vapor and methanol are used as second gas where the average nanoparticle size is drastically reduced from approximately 18 nm to a value close to 8 nm (Figure 7a) with water addition. Note that the injected water vapor represents only 0.6% of the injected gases. Despite such low amount of water vapor, the deposited nanoparticles, on the silicon wafer as substrate (6) into deposition chamber (5), have a mean size that is reduced by a factor of about 2.

While higher amounts of water vapor do not modify substantially the nanoparticles mean size, the effect on the deposition rate is very important as it is increased by a factor of approximately 15. These results clearly show that the presence of small amounts of water molecules in the device have important effects in the synthesis of gold nanoparticles and it is inferred that such effects could also be crucial in the synthesis of nanoparticles of other metals. Inversely, the progressive diminution of water molecules concentration in the residual vacuum that will occur with time as the vacuum pumps continuously remove the water molecules from the vacuum vessel could explain the experimentally observed decrease of NPs deposition rate upon time.

The addition of methanol also has a crucial role on the fabrication process. The evolution of figure 6b evidences that a higher deposition rate is obtained with methanol addition in comparison to the absence of methanol. However, there is a maximum at 0.2 sccm and the rate decreases for higher doses.

### Example 3 Comparative of generated nanoparticles for a long term operational mode of a magnetron sputtering device comprising a FFE with the generated nanoparticles with magnetron sputtering device comprising FFE in presence of a second gas.

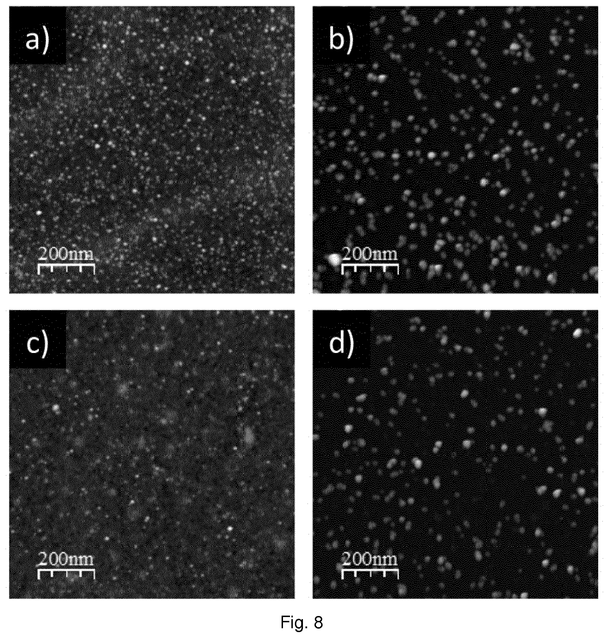

The effect of the presence of a second gas for long term operation is depicted in figure 8. For short operation periods (i.e.: 4 min pre-sputtering, top images Fig. 8) similar deposition rates were found for both deposits, in absence (Fig.8a) and presence of 0.1 sccm CH₃OH (Fig.8b) in terms of NPS/µm²·s. The only significant difference is the increase in the NP size in presence of CH₃OH. However, for long deposition periods (i.e.: 64 min pre-sputtering, bottom images Fig. 8), there is a significant difference when CH₃OH is added. While in absence of CH₃OH (Fig.8c) the NP rate decreases to a 13 % of its initial value, the presence of 0.1 sccm CH₃OH (Fig.8d) during fabrication allow keeping more than 90 % of its initial value shown on the top image.

For standard magnetrons, where operation as long as 60 min are not possible, this effect could not be as important as in the case of the use of FFE, which allows the long term use, and therefore, this effect is crucial for long operation times.

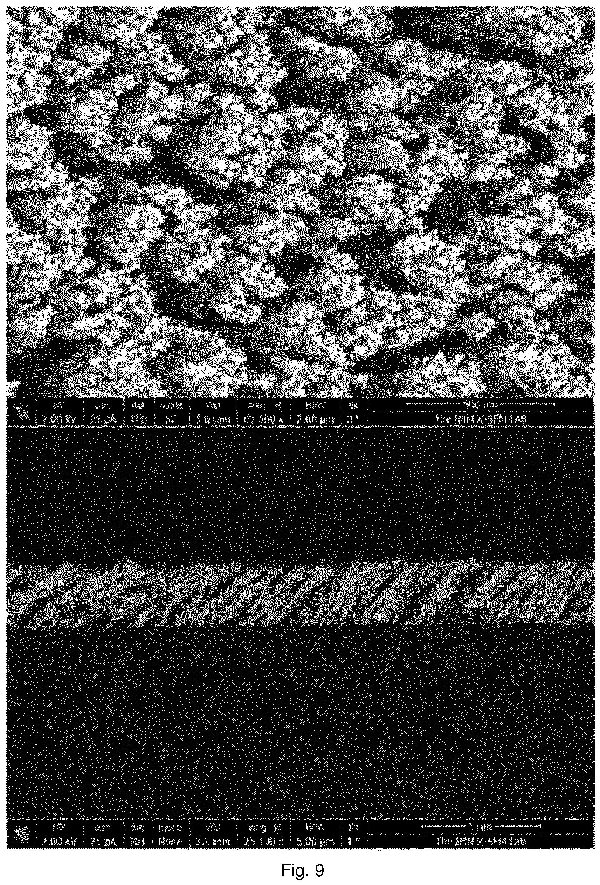

As an example of this, figure 9 presents images of columns of nanoparticles using the FFE and 0.2 sccm CH₃OH. These coral-shaped columns of 600 nm heights were deposited at gracing incident angle during two hours and a half. These kinds of structures have not been reported yet using a sputter gas aggregation sources due to the inherent limitations in terms of stability and efficiency overtime that have been solved with the device proposed here.

## Claims

1. A magnetron sputtering device for the generation of nanoclusters comprising:
a) a first chamber (1) arranged for the generation of nanoclusters working under high or ultra-high vacuum conditions and comprising
- at least a magnetron (3), said magnetron (3) comprising
• a target (2) which is made from any element that is high or ultra-high vacuum compatible and any combination thereof, wherein the target (2) has a diameter of between 2.54 cm to 30.48 cm;
• an arrangement of magnets; and
• at least a first gas source (4), arranged for the delivery of sputtering gas selected from N₂, Ar, He, Ne, Kr, Xe, Ra, O₂ and any combination thereof;
- at least a secondary gas source (7) arranged for delivery of a second gas; wherein the first chamber has a first "a" axis and a second "b" axis, the first axis being greater than the second axis; said device **characterized in that** the magnetron (3) is a full face erosion magnetron;
the second gas is selected from O₂, N₂, H₂O, methanol, air and any combination thereof;
and the arrangement of magnets comprising:
- a statationary magnetic ring with North or South polarity in the direction of the central axis of the magnetic ring; and
- a rotational magnetic disc comprising an off-centre area with inverse magnetic polarity to the polarity of the stationary magnetic ring; wherein the stationary magnetic ring is concentric with respect to the rotational magnetic disc; and wherein the rotational magnetic disc rotates by means of a
- said stationary magnetic ring has a diameter of between 2.54 cm to 30.48 cm;
- said rotational magnetic disc has a diameter of between 1.27 cm and 27.94 cm.

2. The magnetron sputtering device according to claim 1, wherein the stationary magnetic ring has a diameter of between 5.08 cm and 25.4 cm, and the rotational magnetic disc has a diameter of between 2.54 cm and 22.86 cm, and wherein the target has a diameter of between 5.08 cm and 25.4 cm.

3. The magnetron sputtering device according to any of claim 1 to 2, wherein the first chamber (1) comprises more than one magnetron.

4. The magnetron sputtering device according to any of the claims 1 to 3, wherein the magnetron (3) is arranged for moving towards the "a" axis in the first chamber (1).

5. The magnetron sputtering device according to any of the claims 1 to 4, which further comprises at least a second chamber (5).

6. The magnetron sputtering device according to claim 5, wherein the second chamber (5) comprises a deposition means (6) of nanoclusters working under high or ultra-high vacuum.

7. The magnetron sputtering device according to claim 5, wherein the second chamber (5) comprises an analysis and manipulation means of nanoclusters working under high or ultra-high vacuum.

8. The magnetron sputtering device according to claim 7, wherein the analysis means is selected from a mass spectrometer, infrared bath, X-Ray photoelectron spectroscopy (XPS), ultraviolet photoelectron spectroscopy (UPS), Auger electron spectroscopy (AES) low-energy ion spectroscopy (LEIS) thermal desorption spectroscopy and any combination thereof.

9. The magnetron sputtering device according to claim 5, wherein second chamber (5) comprises the deposition means (6) according to claim 6 and the analysis and manipulation means according to claims 7 or 8.

10. The magnetron sputtering device according to any of the claims 1 to 9, which further comprises a separation means between the first and second chamber and filtering means of the nanocluster.

11. The magnetron sputtering device according to claim 10, wherein the separation and filtering means is selected from electromagnetic particle filter, oven, deflecting coils, beam focusing lens, ion traps, and any combination thereof.

## Patentansprüche

1. Magnetron-Sputtervorrichtung zur Erzeugung von Nanoclustern, umfassend:
a) eine erste Kammer (1), die zur Erzeugung von Nanoclustern ausgelegt ist, die unter Hoch- oder Ultrahochvakuumbedingungen arbeiten und umfassend
- mindestens ein Magnetron (3), wobei das Magnetron umfasst
• ein Target (2), das aus einem beliebigen Element hergestellt ist, das mit hoch- oder ultrahochvakuumkompatibel ist, und einer beliebigen Kombination davon, wobei das Target (2) einen Durchmesser zwischen 2,54 cm und 30,48 cm aufweist;
• eine Anordnung von Magneten; und
• mindestens eine erste Gasquelle (4), die zur Abgabe von Sputtergas ausgelegt ist, das ausgewählt ist aus N2, Ar, He, Ne, Kr, Xe, Ra, O2 und einer beliebigen Kombination davon;
- mindestens eine Sekundärgasquelle (7), die zur Abgabe eines zweiten Gases ausgelegt ist; wobei die erste Kammer eine erste "a"-Achse und eine zweite "b"-Achse aufweist, wobei die erste Achse größer als die zweite Achse ist; wobei die Vorrichtung **dadurch gekennzeichnet ist, dass** das Magnetron (3) ein Vollflächenerosionsmagnetron ist;
wobei das zweite Gas ausgewählt ist aus O₂, N₂, H₂O, Methanol, Luft und einer beliebigen Kombination davon;
und die Anordnung von Magneten umfasst:
- ein stationärer magnetischer Ring mit Nord- und Südpolarität in Richtung der zentralen Achse des magnetischen Rings; und
- eine drehbare magnetische Scheibe, umfassend einen außermittigen Bereich mit inverser magnetischer Polarität zu der Polarität des stationären magnetischen Rings;
wobei der stationäre magnetische Ring konzentrisch in Bezug auf die drehbare magnetische Scheibe ist;
und wobei die drehbare magnetische Scheibe mittels eines Motors dreht;
- der stationäre magnetische Ring einen Durchmesser zwischen 2,54 cm bis 30,48 cm aufweist;
- die drehbare magnetische Scheibe einen Durchmesser zwischen 1,27 cm bis 27,94 cm aufweist.

2. Magnetron-Sputtervorrichtung nach Anspruch 1, wobei der stationäre Magnetring einen Durchmesser zwischen 5,08 cm und 25,4 cm aufweist und die drehbare magnetische Scheibe einen Durchmesser zwischen 2,54 cm und 22,86 cm aufweist und wobei das Target einen Durchmesser zwischen 5,08 cm und 25,4 cm aufweist.

3. Magnetronsputtervorrichtung nach einem der Ansprüche 1 bis 2, wobei die erste Kammer (1) mehr als ein Magnetron umfasst.

4. Magnetronsputtervorrichtung nach einem der Ansprüche 1 bis 3, wobei das Magnetron (3) zum Bewegen in Richtung der "a"-Achse in der ersten Kammer (1) ausgelegt ist.

5. Magnetronsputtervorrichtung nach einem der Ansprüche 1 bis 4, die ferner mindestens eine zweite Kammer (5) umfasst.

6. Magnetron-Sputtervorrichtung nach Anspruch 5, wobei die zweite Kammer (5) ein Ablagerungsmittel (6) von Nanoclustern umfasst, die unter Hoch- oder Ultrahochvakuum arbeiten.

7. Magnetron-Sputtervorrichtung nach Anspruch 5, wobei die zweite Kammer (5) ein Analyse- und Manipuliermittel von Nanoclustern umfasst, die unter Hoch- oder Ultrahochvakuum arbeiten.

8. Magnetron-Sputtervorrichtung nach Anspruch 7, wobei das Analysemittel ausgewählt ist aus einem Massenspektrometer, einem Infrarotbad, einer Röntgenphotoelektronenspektroskopie (XPS), einer Ultraviolettphotoelektronenspektroskopie (UPS), einer Auger-Elektronenspektroskopie (AES), einer Niederenergie-Ionenspektroskopie (LEIS), einer thermischen Desorptionsspektroskopie und einer beliebigen Kombination davon.

9. Magnetron-Sputtervorrichtung nach Anspruch 5, wobei die zweite Kammer (5) das Ablagerungsmittel (6) nach Anspruch 6 und das Analyse- und Manipulationsmittel nach den Ansprüchen 7 oder 8 umfasst.

10. Magnetronsputtervorrichtung nach einem der Ansprüche 1 bis 9, die ferner ein Trennmittel zwischen der ersten und der zweiten Kammer und Filtermittel des Nanoclusters umfasst.

11. Magnetron-Sputtervorrichtung nach Anspruch 10, wobei das Trenn- und Filtermittel ausgewählt ist aus einem elektromagnetischen Partikelfilter, Ofen, Ablenkspulen, Strahlfokussierlinse, lonenfallen und jeder Kombination davon.

## Revendications

1. Dispositif de pulvérisation magnétron pour la génération de nanoagrégats comprenant :
a) une première chambre (1) conçue pour la génération de nanoagrégats fonctionnant dans des conditions de vide élevé ou ultra-élevé et comprenant
- au moins un magnétron (3), ledit magnétron (3) comprenant
• une cible (2) fabriquée à partir de tout élément compatible avec le vide élevé ou ultra-élevé et toute combinaison de ceux-ci, dans lequel la cible (2) a un diamètre compris entre 2,54 cm et 30,48 cm ;
• un agencement d'aimants ; et
• au moins une première source de gaz (4), conçue pour la délivrance d'un gaz de pulvérisation choisi parmi N₂, Ar, He, Ne, Kr, Xe, Ra, O₂ et toute combinaison de ceux-ci ;
- au moins une seconde source de gaz (7) conçue pour la délivrance d'un second gaz ;
dans lequel la première chambre a un premier axe « a » et un second axe « b », le premier axe étant plus grand que le second axe ; ledit dispositif **caractérisé en ce que** le magnétron (3) est un magnétron à érosion totale de la face ;
le second gaz est choisi parmi O₂, N₂, H₂O, le méthanol, l'air et toute combinaison de ceux-ci ;
et l'agencement d'aimants comprenant :
- un anneau magnétique stationnaire avec une polarité Nord ou Sud dans la direction de l'axe central de l'anneau magnétique ; et
- un disque magnétique rotatif comprenant une zone décentrée dont la polarité magnétique est inverse à celle de l'anneau magnétique stationnaire ;
dans lequel l'anneau magnétique stationnaire est concentrique par rapport au disque magnétique rotatif ; et dans lequel le disque magnétique rotatif tourne au moyen d'un moteur ;
- ledit anneau magnétique stationnaire a un diamètre compris entre 2,54 cm et 30,48 cm ;
- ledit disque magnétique rotatif a un diamètre compris entre 1,27 cm et 27,94 cm.

2. Dispositif de pulvérisation magnétron selon la revendication 1, dans lequel l'anneau magnétique stationnaire a un diamètre compris entre 5,08 cm et 25,4 cm, et le disque magnétique rotatif a un diamètre compris entre 2,54 cm et 22,86 cm, et dans lequel la cible a un diamètre compris entre 5,08 cm et 25,4 cm.

3. Dispositif de pulvérisation magnétron selon l'une quelconque des revendications 1 à 2, dans lequel la première chambre (1) comprend plus d'un magnétron.

4. Dispositif de pulvérisation magnétron selon l'une quelconque des revendications 1 à 3, dans lequel le magnétron (3) est conçu pour aller vers l'axe « a » dans la première chambre (1).

5. Dispositif de pulvérisation magnétron selon l'une quelconque des revendications 1 à 4, comprenant en outre, au moins, une seconde chambre (5).

6. Dispositif de pulvérisation magnétron selon la revendication 5, dans lequel la seconde chambre (5) comprend un moyen de dépôt (6) de nanoagrégats fonctionnant sous vide élevé ou ultra-élevé.

7. Dispositif de pulvérisation magnétron selon la revendication 5, dans lequel la seconde chambre (5) comprend un moyen d'analyse et de manipulation de nanoagrégats fonctionnant sous vide élevé ou ultra-élevé.

8. Dispositif de pulvérisation magnétron selon la revendication 7, dans lequel le moyen d'analyse est choisi parmi un spectromètre de masse, un bain infrarouge, une spectroscopie photoélectronique à rayons X (XPS), une spectroscopie photoélectronique à ultraviolets (UPS), une spectroscopie d'électrons Auger (AES), une spectroscopie ionique à basse énergie (LEIS), une spectroscopie de désorption thermique et toute combinaison de ceux-ci.

9. Dispositif de pulvérisation magnétron selon la revendication 5, dans lequel la seconde chambre (5) comprend le moyen de dépôt (6) selon la revendication 6 et le moyen d'analyse et de manipulation selon la revendication 7 ou 8.

10. Dispositif de pulvérisation magnétron selon l'une quelconque des revendications 1 à 9, comprenant en outre un moyen de séparation entre la première et la seconde chambre et un moyen de filtrage du nanoagrégat.

11. Dispositif de pulvérisation magnétron selon la revendication 10, dans lequel les moyens de séparation et de filtrage sont choisis parmi un filtre à particules électromagnétiques, un four, des bobines de déviation, une lentille de focalisation de faisceau, des pièges à ions, et toute combinaison de ceux-ci.
